# EUROPÄISCHE PATENTSCHRIFT

(11) **EP 0 505 867 B1**
(45) Veröffentlichungstag und Bekanntmachung des Hinweises auf die Patenterteilung: **05.03.1997**
(21) Anmeldenummer: 92104469.9
(22) Anmeldetag: 16.03.1992
(51) Int. Cl.: H04B 1/12

(54) **Verfahren zur Nachbarkanalunterdrückung beim Empfang frequenzmodulierter Sender**
Method for adjacent channel rejection at reception of FM modulated transmitters
Procédé pour éliminer les signaux des canaux adjacents en réception FM

(30) Priorität: 27.03.1991 DE 4110083
(43) Veröffentlichungstag der Anmeldung: 30.09.1992
(73) Patentinhaber: Blaupunkt-Werke GmbH, D-31132 Hildesheim (DE)
(72) Erfinder: Rüngeler, Andreas, Dr., W-7141 Benningen (DE); Raichle, Franz, W-7016 Gerlingen (DE)

(56) Entgegenhaltungen:
- GB-A- 2 069 297
- US-A- 4 191 926
- US-A- 4 349 916
- PATENT ABSTRACTS OF JAPAN vol. 8, no. 194 (E-264)(1631) 6. September 1984 & JP-A-59 083 405

## Beschreibung

Die Erfindung betrifft ein Verfahren zur Nachbarkanalunterdrückung beim Empfang frequenzmodulierter Sender nach dem Oberbegriff des Anspruchs 1.

Das Frequenzspektrum frequenzmodulierter Sender ist an sich unendlich breit. In der Praxis lassen sich jedoch Stereosignale, deren Kanäle das hörbare Frequenzspektrum von 30̸ bis 150̸0̸0̸ Hz enthalten, mit hinreichend geringen Verzerrungen wiedergeben, wenn empfangsseitig die Bandbreite des frequenzmodulierten Signals durch ZF-Filterung auf ca. 30̸0̸ kHz beschränkt wird.

Um hierbei die einzelnen Sender einwandfrei selektieren zu können, müßten die Sender in einem Kanalraster von mindestens 300 kHz arbeiten. Tatsächlich beträgt das Kanalraster aber nur 100 kHz. Dieser Umstand wäre dann nicht störend, wenn die Sendefrequenzen in Verbindung mit den Senderstandorten so koordiniert wären, daß aufgrund der begrenzten Reichweiten von UKW-Sendern sichergestellt wäre, daß an jedem möglichen geografischen Standort nur solche Sender einfallen, die einen gegenseitigen Frequenzabstand von mindestens 300 kHz aufweisen.

Durch den Ausbau des Sendernetzes werden die Bedingungen für einen ungestörten Empfang jedoch nicht mehr an jedem geografischen Standort eingehalten. So kommt es vor, daß zusätzlich zu dem Nutzsignal des Senders, auf den der Empfänger abgestimmt wurde, ein Störsignal eines auf dem Nachbarkanal arbeitenden Senders empfangen wird. Das Signalgemisch aus Nutzsignal und Störsignal läßt sich durch analoge ZF-Filterung nicht trennen.

Aus der US-A-4 191 926 ist eine Anordnung zur Nachbarkanalunterdrückung winkelmodulierter Signale bekannt, wobei über eine erste Antenne das durch eine Störfrequenz beeinträchtigte gewünschte Signal, über eine zweite Antenne das Störsignal empfangen wird. Die beiden Signale werden jeweils mittels eines auf die jeweilige Trägerfrequenz abgestimmten Filters gefiltert und anschließend miteinander multipliziert. Der niederfrequente Anteil des Produktes wird nach Phasendrehung und Abschwächung von dem winkeldemodulierten gefilterten störbehafteten Nutzsignal subtrahiert, so daß am Ausgang des Subtrahierers das gewünschte Nutzsignal im Basisband vorliegt.

In "Optimierung gekoppelter digitaler PLL-Schaltungen zur Reduzierung von Interferenzstörungen in FM-Empfängern" von Martin Schlereth, Lehrstuhl für Nachrichtentechnik, Universität Erlangen-Nürnberg, Juni 1987 wurde bereits vorgeschlagen, zur Demodulation von frequenzmodulierten Signalen mit überlappenden Spektren komplexe digitale Basisbandsignale zu gewinnen und diese Signale mit Hilfe zweier Demodulatoren, die jeweils auf einen der Träger der frequenzmodulierten Signale abgestimmt sind, zu demodulieren. Dabei lassen sich Schätzsignale für die Phase und die Amplitude des einen und des anderen Signals gewinnen. Weiterhin wurde vorgeschlagen, durch gegenseitige Kopplung der Demodulatoren in einer Kreuzstruktur nach Remodulation der Schätzsignale diese von den komplexen digitalen Basisbandsignalen gegenseitig abzuziehen. Dadurch lassen sich im eingeschwungenen Zustand die den überlappenden Spektren entsprechenden Signale trennen.

Es hat sich gezeigt, daß die Anordnung von Demodulatoren in Kreuzstruktur zur Instabilität neigt. Dies rührt daher daß im eingeschwungenen Zustand eine Umsynchronisation eintreten kann, wenn der an sich dem Nutzsignal zugeordnete Demodulator auf das Störsignal synchronisiert und der ursprünglich dem Störsignal zugeordnete Demodulator auf das Nutzsignal synchronisiert. Dieser Fall kann bei Gleichheit der Zustandsgrößen der Phasenregelkreise der digitalen PLL-Demodulatoren eintreten. Der Vorgang der ständigen Umsynchronisation führt zu einer erheblichen Beeinträchtigung des Höreindruckes.

Der Erfindung liegt die Aufgabe zugrunde, ein Verfahren zur Nachbarkanalunterdrückung beim Empfang frequenzmodulierter Signale dahingehend zu verbessern, daß unabhängig von den Zustandsgrößen der Demodulatoren eine sichere Trennung von Nutz- und Störsignal erreicht werden kann.

Diese Aufgabe wird bei einem Verfahren nach dem Oberbegriff des Anspruchs 1 durch die im kennzeichnenden Teil angegebenen Merkmale gelöst.

Die Erfindung geht von einer Geradeausstruktur bei der Signalverarbeitung aus und vermeidet eine gegenseitige Kopplung der Demodulatoren für das Nutz- und das Störsignal. Durch die Verwendung von unterschiedlichen ZF-Filtern gelingt es, den einen Demodulator eindeutig dem Nutzsignal und den anderen Demodulator eindeutig dem Störsignal zuzuordnen. Somit wird die Entstehung gleicher Zustandsgrößen, die bei der bekannten Kreuzkopplung zur Umsynchronisation führen kann, vermieden.

Um aus dem Störsignal einen Schätzwert zu erzeugen, der anschließend nach Remodulation in der Lage ist, den Störanteil im Nutzsignal zu kompensieren, wird mit Hilfe der Charakteristik des ZF-Filters im Nutzsignalweg die Momentanamplitude des Störsignals im Nutzsignalweg geschätzt. Da der Frequenzgang der Amplitude des ZF-Filters alle Frequenzen des FM-Spektrums beeinflußt und dieser Zusammenhang nicht einfach angegeben werden kann, wird ein quasistatisches Modell benutzt, das unter bestimmten Bedingungen eine einfache Näherung zur Bestimmung des Einflusses des ZF-Filters ermöglicht. Dieses quasistatische Modell nimmt an, daß aufgrund kleiner Werte für die Modulationsfrequenz und den Frequenzhub die Frequenzänderung der FM-Schwingung so langsam erfolgt, daß sich das System in jedem Augenblick im eingeschwungenen Zustand befindet. In diesem Fall muß zur Berechnung des Einflusses des ZF-Filters auf die Momentanamplitude nicht das gesamte Frequenzband betrachtet werden, sondern es genügt, lediglich den Wert des Betragsfrequenzganges des ZF-Filters bei der im Augenblick demodulierten Momentanfrequenz zu bestimmen.

Nachfolgend wird die Erfindung anhand der Zeichnung erläutert. Diese zeigt:
ein Blockschaltbild des ZF- und Demodulator-Teils eines FM-Empfängers mit zwei in Geradeausstruktur angeordneten digitalen PLL-Schaltkreisen als Demodulatoren.

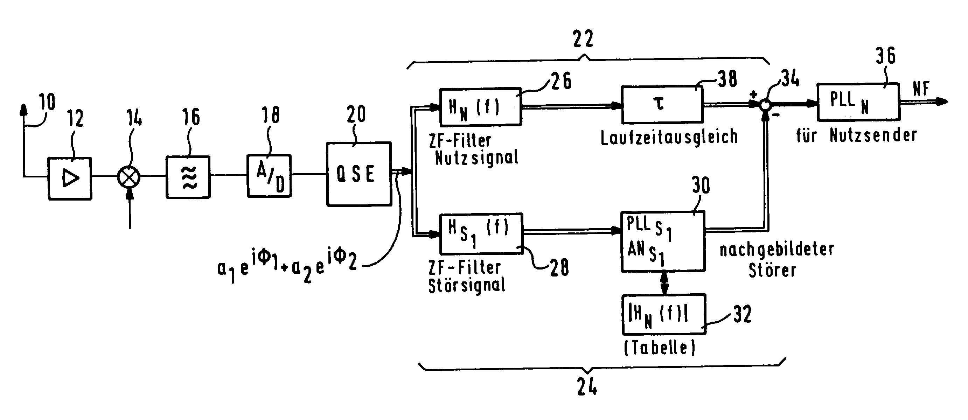

Bei der Schaltung gemäß Fig. 1 gelangen Signale von einer Antenne 10̸ über einen Vorverstärker 12 und eine Mischstufe 14 zu einem analogen ZF-Filter 16. Am Ausgang des analogen ZF-Filters 16 steht ein frequenzmoduliertes ZF-Signal der Mittenfrequenz 10̸,7 MHz an. Dieses ZF-Signal wird in einem nachfolgenden Analog-Digitalwandler 18 mit der Abtastfrequenz fA abgetastet und in ein digitales Signal umgewandelt. In einem weiteren Schaltkreis 20̸ zur Quadratursignalerzeugung wird das digitale Signal durch Abtastreduktion ins komplexe Basisband abgemischt. anschließend erfolgt eine Aufteilung in einen ersten Signalweg 22 für das Nutzsignal und einen weiteren Signalweg 24 für das Störsignal.

An den Eingängen der Signalwege 22 und 24 befinden sich ZF-Filter 26 und 28, von denen das im Nutzsignalweg 22 angeordnete ZF-Filter 26 auf die Mittenfrequenz bzw. den Frequenzgang des Nutzsignals und das im Störsignalweg 24 angeordnete ZF-Filter 28 auf die Mittenfrequenz bzw. den Frequenzgang des Störsignals abgestimmt ist. Das ZF-Filter zur Nachbildung des Störers ist dabei um den Trägerversatz zwischen dem Störträger und dem Nutzträger verstimmt.

Dadurch wird erreicht, daß das Störsignal im Signalweg 24 nicht teilweise unterdrückt wird und dadurch besser als bei der kreuzgekoppelten Ausführung nachgebildet werden kann. Die Amplitude des Störers im Nutzsignalweg wird auf der Grundlage eines quasistischen Modells ermittelt, wobei die Charakteristik des im anderen Signalweg, also im Nutzsignalweg 22 angeordneten ZF-Filters 26 zu berücksichtigen ist.

Dazu wird das Störsignal einem digitalen PLL-Schaltkreis 30̸ zugeführt und die Momentanfrequenz des demodulierten Signals zur Adressierung der in einer Tabelle eines adressierbaren Speichers 32 abgelegten ZF-Charakteristik des im Nutzsignalweg 22 angeordneten ZF-Filters 26 herangezogen. Daraus ergibt sich ein Schätzsignal für die bei der entsprechenden Momentanfrequenz durch das ZF-Filter 26 verursachte Bewertung des Störsignals im Nutzsignalweg. Das Ergebnis ist ein nachgebildeter Amplitudenverlauf des Störsignals im Nutzsignalweg, der sehr genau den Verhältnissen im Nutzsignalweg 22 angepaßt ist.

Nach Remodulation, die in dem Blockschaltbild nicht als gesonderter Schaltkreis dargestellt ist, kann nun ein komplexes Basisbandsignal mit einer Störkomponente erzeugt werden, die der Störkomponente im Nutzsignalweg 22 entspricht. In einer Verknüpfungsstelle 34 läßt sich nunmehr das nachgebildete Störsignal vom gestörten Nutzsignal abziehen, so daß dem im Nutzsignalweg 22 angeordneten digitalen PLL-Schaltkreis 36 ein störbefreites Nutzsignal zugeführt werden kann. Laufzeitunterschiede zwischen dem gestörten Nutzsignal und dem nachgebildeten Störsignal lassen sich durch ein vor der Verknüpfungsstelle 34 angeordnetes Laufzeitglied 38 ausgleichen.

Gegenüber der kreuzgekoppelten Struktur bietet die hier beschriebene Geradeausstruktur der Demodulatoren folgende Vorteile. Signallaufzeitunterschiede können durch ein Laufzeitglied ausgeglichen werden. Bei der kreuzgekoppelten Struktur ist dies grundsätzlich nicht möglich. Dadurch können Filter zur Amplitudennachbildung höhergradig ausgelegt werden.

Der Demodulator im Nutzsignalweg detektiert nur das Nutzsignal. Eine Nachbildung des Nutzsignals für den Störsignalweg ist nicht erforderlich.

Da eine Rückführung des remodulierten Nutzsignals auf eine Verknüpfungsstelle vor dem digitalen PLL-Schaltkreis für die Störsignaldemodulation fehlt, läßt sich das Verhalten der Schaltung einfacher beschreiben und die Schaltung zuverlässiger auslegen.

Beim Entwurf des ZF-Filters bieten sich mehr Freiheitsgrade. So kann z. B. das Filter schmalbandig für das Einschwingverhalten und breitbandig für den eingeschwungenen Zustand ausgelegt werden.

Durch die Verwendung eines zusätzlichen ZF-Filters für das Störsignal ist eine bessere Nachbildung des Störers möglich. Eine Amplitudennachbildung des Nutzsignals ist nicht erforderlich.

Eine Kompensation weiterer Störsignale ist durch einfaches Hinzufügen weiterer Störsignalnachbildungszweige möglich. Dadurch gelingt eine erfolgreiche Unterdrückung von Nachbarkanalstörungen, die z. B. durch ein oder mehrere oberhalb und unterhalb des Nutzsenders liegende Nachbarkanalstörsender hervorgerufen werden.

## Patentansprüche

1. Verfahren zur Nachbarkanalunterdrückung beim Empfang frequenzmodulierter Signale, bei dem ein Signalgemisch aus einem Nutzsignal und einem aus einem Nachbarkanal stammenden Störsignal nach analoger ZF-Filterung, Analog-Digital-Wandlung und Quadratursignalbildung in ein komplexes Basisbandsignal der Form a1 e ^{iΦ1} + a2 e ^{iΦ2} überführt wird, wobei a1 die Amplitude des Nutzsignals, a2 die Amplitude des Störsignals, Φ1 die Phase des Nutzsignals und Φ2 die Phase des Störsignals darstellen, und durch Demodulation des Störsignals unter Berücksichtigung von auf dem Signalweg eintretenden Verzerrungen Schätzwerte für die Momentanamplitude und Momentanphase des Störsignals ermittelt werden, die nach Remodulation vom komplexen Basisbandsignal abgezogen werden, dadurch gekennzeichnet, daß das Störsignal und das Nutzsignal in getrennten, auf den jeweiligen Frequenzgang ihres Spektrums abgestimmten ZF-Filtern gefiltert werden und daß anschließend Schätzwerte der Momentanamplitude des Störsignals im Nutzsignalweg mit Hilfe der ZF-Filtercharakteristik des Nutzsignalweges und der im Störsignalweg ermittelten Momentanfrequenz des Störsignals gewonnen werden.

2. Verfahren nach Anspruch 1, dadurch gekennzeichnet, daß zur Schätzung des Störsignals ein zum momentanen Frequenzwert des demodulierten Störsignals korrespondierender Amplitudenschätzwert des ZF-Filters des Nutzsignalweges einer Tabelle (|H_{N}(f)|) entnommen und daß nach Remodulation das komplexe Störsignal von dem laufzeitangepaßten komplexen Nutzsignal phasenrichtig abgezogen wird.

## Claims

1. Method for adjacent channel rejection for the reception of frequency-modulated signals in which a signal mixture composed of a wanted signal and an interference signal originating from an adjacent channel is changed, after analogue IF filtering, analogue to digital conversion and quadrature signal formation into a complex baseband signal in the form a1 e ^{iΦ1} + a2 e ^{iΦ2}, a1 representing the amplitude of the wanted signal, a2 the amplitude of the interference signal, Φ1 the phase of the wanted signal and Φ2 the phase of the interference signal, and estimated values of the instantaneous amplitude and instantaneous phase of the interference signal being determined by demodulation of the interference signal taking account of distortion occurring on the signal path, which estimated values are subtracted after remodulation of the complex baseband signal, characterized in that the interference signal and the wanted signal are filtered in separate IF filters tuned to the respective frequency response of their spectrum, and in that, subsequently, estimated values of the instantaneous amplitude of the interference signal in the wanted signal path are obtained with the aid of the IF filter characteristic of the wanted signal path and the instantaneous frequency, determined in the interference signal path, of the interference signal.

2. Method according to Claim 1, characterized in that an estimated amplitude value, corresponding to the instantaneous frequency value of the demodulated interference signal, of the IF filter of the wanted signal path is taken from a table (¦H_{N}(f)¦) in order to estimate the interference signal, and in that, after remodulation, the complex interference signal is subtracted in the correct phase from the complex wanted signal, whose delay time is matched.

## Revendications

1. Procédé pour éliminer les signaux de canaux adjacents en réception FM dans lequel un signal mélangé comprend un signal utile et un signal parasite venant d'un canal voisin qui est transformé après un filtrage FI analogique, une commutation analogique-numérique et la formation d'un signal en quadrature en un signal de bande de base complexe de la forme a1·e ^{iΦ1} + a2·e ^{iΦ2}, a1 étant l'amplitude du signal utile, a2 l'amplitude du signal parasite, Φ1 la phase du signal utile, Φ2 la phase du signal parasite, des valeurs évaluées de commutation pour l'amplitude instantanée et la phase instantanée du signal parasite étant obtenues par démodulation du signal parasite en fonction des distorsions du chemin de signal, et ces valeurs d'évaluation étant soustraites après remodulation du signal de base de bande complexe,
caractérisé en ce que
le signal parasite et le signal utile sont filtrés séparément dans des filtres Fi réglés sur chacune des fréquences de leur spectre et on obtient des fréquences instantanées du signal parasite en fonction de valeurs d'évaluation de l'amplitude instantanée du signal parasite dans le chemin de signal utile à l'aide des caractéristiques des filtres FI du chemin de signal utile et du chemin de signal parasite.

2. Procédé selon la revendication 1,
caractérisé en ce que
pour évaluer le signal parasite, on prend dans un tableau (|H_{N} (f)|), une valeur évaluée de l'amplitude correspondant à la valeur instantanée de la fréquence du signal parasite démodulé pour le filtre FI du chemin de signal utile et en ce que l'on retranche le signal parasite complexe du signal utile complexe adapté en temps de parcours en respectant les phases.
